Europäisches Patentamt

European Patent Office

Office européen des brevets

(19)

(11) EP 0 477 096 B1

(12) FASCICULE DE BREVET EUROPEEN

(45) Date de publication et mention
de la délivrance du brevet:
14.01.1998 Bulletin 1998/03

(51) Int Cl.6: H01L 21/20, H01L 21/36

(21) Numéro de dépôt: 91402484.9

(22) Date de dépôt: 18.09.1991

(54) **Procédé d'épitaxie sélective et de gravure de matèriau III-V ou II-VI dans un même bâti de croissance OMCVD**

Verfahren zum selektiven epitaxialen Wachstum und Ätzen von III-V oder II-VI-Halbleitern in demselben Wachstumsapparat

Process for selective epitaxial growth and etching of III-V or II-VI compounds in the same MOCVD growth apparatus

(84) Etats contractants désignés:
DE GB

(30) Priorité: 20.09.1990 FR 9011615

(43) Date de publication de la demande:
25.03.1992 Bulletin 1992/13

(73) Titulaire: FRANCE TELECOM
92131 Issy les Moulineaux (FR)

(72) Inventeurs:
• Azoulay, Rosette
F-92260 Fontenay aux Roses (FR)
• Dugrand, Louis
F-77500 Chelles (FR)

(74) Mandataire: Dubois-Chabert, Guy et al
Société de Protection des Inventions
25, rue de Ponthieu
75008 Paris (FR)

(56) Documents cités:
DE-A- 3 726 971         US-A- 3 406 048

• PATENT ABSTRACTS OF JAPAN vol. 11, no. 75 (C-408)6 Mars 1987 & JP-A-61 232 297 ( NEC CORP ) 16 Octobre 1986
• PATENT ABSTRACTS OF JAPAN vol. 13, no. 453 (E-831)11 Octobre 1989 & JP-A-01 175 727 ( NEC )
• JOURNAL OF THE ELECTROCHEMICAL SOCIETY. vol. 126, no. 7, Juillet 1979, MANCHESTER, NEW HAMPSHIRE US pages 1241 - 1247; SANKARAN ET AL: 'Selective in situ vapor etch and growth of GaAs'
• JOURNAL OF THE ELECTROCHEMICAL SOCIETY. vol. 113, no. 9, Septembre 1966, MANCHESTER, NEW HAMPSHIRE US pages 904 - 908; SHAW: 'Selective deposition of gallium arsenide in holes'
• JOURNAL OF CRYSTAL GROWTH. vol. 99, no. 1/4, Janvier 1990, AMSTERDAM NL pages 324 - 328; KUECH ET AL: 'Selective epitaxy of MOVPE GaAs using diethylgalliumchloride'
• Applied Physics Letters, 45(11) p. 1241-7
• J.J.A.P., 22(9) pp583-5
• J. Crystal Growth 57(1982)15-20
• Applied Physics Letters 48(6), 417-8
• J. Crystal Growth, 59(1982) 155-160

# Description

L'invention a pour objet un procédé d'épitaxie sélective et éventuellement de gravure de matériau III-V ou II-VI dans un bâti de croissance OMCVD permettant notamment la réalisation de structures semi-conductrices multicouches, épitaxiées, utilisables en particulier en microélectronique et en optoélectronique. Ces structures sont donc destinées à la fabrication de circuits intégrés, de sources lasers enterrées, de composants intégrés laser-guide d'onde, de photodétecteurs, ... L'invention s'applique plus spécialement dans le domaine des télécommunications.

On rappelle qu'un matériau III-V est un matériau contenant un ou plusieurs éléments de la colonne III et un ou plusieurs éléments de la colonne V de la classification périodique des éléments et qu'un matériau II-VI est un matériau contenant au moins un élément II et au moins un élément VI de cette classification.

L'intégration de plusieurs composants III-V ou II-VI sur une même plaque support est un but visé par les fabricants, tant en microélectronique qu'en optoélectronique. Pour cela, il est nécessaire de maîtriser les techniques de gravure et d'épitaxie sélective de ces matériaux.

On appelle épitaxie sélective la technique qui permet de faire un dépôt monocristallin localisé sur un substrat monocristallin masqué partiellement par une couche de diélectrique ou une couche métallique. L'épitaxie est dite totalement sélective lorsque la croissance n'a lieu que dans les ouvertures du masque et qu'aucun dépôt n'est observé sur le masque, quelles que soient les dimensions relatives des parties masquées et non masquées.

D'autre part, si la structure finale est plane, c'est-à-dire que tous les composants sont sur le même niveau, les étapes technologiques ultérieures seront facilitées. Il faut donc pouvoir graver une plaque suivant une forme voulue et déposer sélectivement les composants dans les creux ou les sillons ainsi définis.

Il s'agit donc de réaliser les étapes suivantes :

- 1. Dépôt du masque,
- 2. Gravure du masque,
- 3. Gravure du substrat à travers les ouvertures du masque,
- 4. Epitaxie sélective du composant dans les ouvertures du masque.

Actuellement, les étapes 3 et 4 se font dans des bâtis différents, ce qui peut entraîner une pollution de la surface du substrat lors du transfert de l'échantillon de la chambre de gravure à la chambre d'épitaxie. Ceci est en particulier dû aux types distincts de gravure et d'épitaxie généralement utilisés.

En effet, actuellement l'épitaxie de matériaux III-V se fait soit par croissance par jet moléculaire, notée MBE, opérant dans des conditions d'ultravide, soit par croissance en phase vapeur utilisant des composés organométalliques, notée OMCVD, opérant sous pression atmosphérique ou basse pression ; par ailleurs la gravure de ces matériaux se fait actuellement soit par voie humide, c'est-à-dire par attaque chimique avec des mélanges d'acides en solution, à pression atmosphérique, soit par voie sèche telle qu'une gravure ionique réactive (RIE) à basse pression. En particulier, le document FR-A-2 615 655 déposé au nom de L. Henry et C. Vaudry enseigne une gravure RIE avec un mélange gazeux de $CH_4/Ar/H_2$ à des pressions de 1 à 4 Pa.

De plus, les méthodes d'épitaxie et de gravure connues présentent toutes certains inconvénients.

De façon générale, l'épitaxie OMCVD de GaAs se fait à pression atmosphérique en partant de triméthylgallium (TMG) et de $AsH_3$ ou arsine comme sources respectives de gallium et d'arsenic. Pour l'épitaxie de GaAlAs, on utilise en plus du triméthylaluminium (TMAl) comme source d'aluminium. Lorsque l'épitaxie a lieu sur un substrat recouvert d'un diélectrique comme masque, la croissance de GaAs ou de GaAlAs est monocristalline dans les ouvertures du masque et généralement polycristalline sur le diélectrique. Ce type de croissance n'est donc pas totalement sélectif.

Pour obtenir une épitaxie totalement sélective de GaAs, c'est-à-dire sans dépôt sur le diélectrique, deux approches d'épitaxie OMCVD ont été étudiées, l'une faisant varier les conditions physiques de la croissance (pression du réacteur, température du substrat), l'autre faisant varier les conditions chimiques de la croissance (fabrication de nouvelles molécules).

Ces méthodes d'épitaxie OMCVD totalement sélective connues introduisent malheureusement des contraintes spécifiques telles que la nécessité d'épitaxier à basse pression, ce qui introduit une contrainte supplémentaire du procédé qui peut être gênante (conditions de mise en oeuvre plus délicates, augmentation du coût de fabrication par exemple), ou la nécessité de synthétiser des molécules particulières pour chaque matériau à épitaxier.

En particulier, l'épitaxie totalement sélective de GaAs à basse pression (10 torrs, soit $1,3.10^3$ Pa) sur un substrat en GaAs partiellement masqué par du $SiN_x$ a été décrite dans l'article Journal of Crystal Growth 73 (1985) 73-76 de K. Kamon et al., "Selective epitaxial growth of GaAs by low-pressure MOVPE". Cette épitaxie est réalisée en partant du TMG et d'arsine comme sources respectives de gallium et d'arsenic.

On connaît aussi par l'article de G. Ghosh et R.L. Layman "Selective area growth of gallium arsenide by metalorganic vapor phase epitaxy" dans Appl. Phys. Lett. 45(11),p. 1229-1231, un procédé d'épitaxie sélective de GaAs sur des substrats en partie recouverts de $SiO_2$.

Dans l'article de T.F. Kuech et al., Appl. Phys. Lett. 54 (10) du 6 mars 1989, p. 910-912, "Selective epitaxy in the conventional métalorganic vapor phase epitaxy of GaAs", il est décrit une épitaxie totalement sélective de GaAs en utilisant comme précurseur du gallium du chlorure de diéthylgallium (DEGaCl) sous basse pression (90 Torrs, soit $1,2.10^3$ Pa). En plus des contraintes liées à l'utilisation de basses pressions, c'est-à-dire inférieures à la pression atmosphérique, ce procédé nécessite la fabrication de molécules particulières, non disponibles dans le commerce, compliquant le procédé et augmentant son coût.

La croissance MBE et la gravure RIE connues ont, quant à elles, l'inconvénient d'utiliser des basses pressions (d'où contraintes de mise en oeuvre) et la gravure humide présente l'inconvénient d'être isotrope, ce qui ne permet pas l'obtention des motifs gravés de dimensions microniques voire submicroniques.

L'invention propose donc un procédé d'épitaxie totalement sélective et de gravure dans un bâti de croissance OMCVD permettant de remédier aux inconvénients ci-dessus. En particulier, ce procédé met en oeuvre les conditions physiques classiques de croissance et les espèces chimiques généralement utilisées pour cette croissance qui sont disponibles dans le commerce. Ce procédé permet en outre la gravure des substrats III-V ou II-VI dans le même bâti de croissance.

De façon plus précise, l'invention a pour objet un procédé d'épitaxie sélective d'une couche semi-conductrice constituée d'au moins un élément III et d'au moins un élément V comportant les étapes suivantes :

a) - déposer sur un matériau monocristallin (2) III-V une couche de masque (6), en matériau diélectrique ou en métal, résistant à l'épitaxie,

b) - graver la couche de masque pour y former des ouvertures (9) correspondant aux zones du matériau monocristallin sur lesquelles doit être réalisée l'épitaxie sélective,

c) - graver (12) dans un bâti OMCVD à pression atmosphérique des zones non masquées du matériau monocristallin à l'aide d'un ou plusieurs halogénures d'un de ces éléments III ou V constituant le matériau monocristallin,

d)-épitaxier dans le même bâti OMCVD la couche semiconductrice (14) sur les zones du matériau sur lesquelles doit être réalisée l'épitaxie sélective, l'étape d) consistant à soumettre, sous pression atmosphérique, ledit matériau monocristallin masqué et gravé simultanément à des vapeurs d'espèces chimiques d'au moins un élément III et d'au moins un élément V, ainsi qu'à des vapeurs d'acide chlorhydrique ou d'au moins un halogénure d'un élément V, les éléments III et V des espèces chimiques et de l'halogénure étant ceux destinés à constituer la couche semi-conductrice, lesdites espèces chimiques étant des organo-métalliques et/ou des composés hydrogénés.

L'invention a également pour objet un procédé d'épitaxie sélective d'une couche semi-conductrice constituée d'au moins un élément II et d'au moins un élément VI comportant les étapes suivantes :

a) - déposer sur un matériau monocristallin (2) II-VI une couche de masque (6), en matériau diélectrique ou en métal, résistant à l'épitaxie,

b) - graver la couche de masque pour y former des ouvertures (9) correspondant aux zones du matériau monocristallin sur lesquelles doit être réalisée l'épitaxie sélective,

c) - graver (12) dans un bâti OMCVD à pression atmosphérique des zones non masquées du matériau monocristallin à l'aide d'un ou plusieurs halogénures d'un de ces éléments II ou VI constituant le matériau monocristallin,

d)-épitaxier dans le même bâti OMCVD la couche semiconductrice (14) sur les zones du matériau monocristallin sur lesquelles doit être réalisée l'épitaxie sélective, l'étape d) consistant à soumettre, sous pression atmosphérique, ledit matériau monocristallin masqué et gravé, simultanément à des vapeurs d'espèces chimiques d'au moins un élément II et d'au moins un élément VI, ainsi qu'à des vapeurs d'acide chlorhydrique ou d'au moins un halogénure d'un élément VI, les éléments II et VI des espèces chimiques et de l'halogénure étant ceux destinés à constituer la couche semi-conductrice, lesdites espèces chimiques étant des organo-métalliques et/ou des composés hydrogénés.

Par matériau monocristallin, il faut comprendre un substrat massif monocristallin, une couche semi-conductrice monocristalline épitaxiée sur le substrat ou encore un empilement de couches semi-conductrices monocristallines.

Le procédé selon l'invention s'applique à toute couche semi-conductrice et matériau III-V, binaire, ternaire ou quaternaire. En particulier, l'élément III est choisi parmi le gallium, l'indium, l'aluminium et leurs mélanges et l'élément V est choisi parmi le phosphore, l'arsenic, l'antimoine et leurs mélanges.

L'invention s'applique particulièrement bien à l'épitaxie sélective de GaAs, de $Ga_{1-x}Al_x$ As avec $0<x\leq1$, mais aussi à l'épitaxie de InP, GaInAs, GaInAsP pour toutes les compositions en indium et/ou phosphore.

De même, le procédé s'applique à toute couche semi-conductrice et matériau II-VI binaire, ternaire ou quaternaire. En particulier, l'élément II est choisi parmi le zinc, le cadmium, le mercure et leurs mélanges et l'élément VI est choisi parmi le soufre, le sélénium, le tellure et leurs mélanges.

La croissance des couches semi-conductrices III-V se fait soit par décomposition thermique de polyalkyle de l'élément III et de polyalkyle de l'élément V, soit par décomposition thermique de polyalkyle de l'élément III et de composés hydrogénés de l'élément V.

De même, la croissance des couches II-VI se fait soit par décomposition thermique de polyalkyle de l'élément II et de polyalkyle de l'élément VI, soit par décomposition thermique de polyalkyle de l'élément II et de composés hydrogénés de l'élément VI.

Les radicaux alkyles utilisés comportent de 1 à 3 atomes de carbone.

En particulier, le dépôt de couches semi-conductrices contenant du gallium, de l'indium ou de l'aluminium se fait respectivement par décomposition de triméthylgallium (TMG) ou de triéthylgallium (TEG) ; de triéthylindium (TEI) ou de triméthylindium (TMI) et de triméthylaluminium (TMAl).

Le dépôt de couches semi-conductrices contenant du phosphore, de l'arsenic ou de l'antimoine se fait par décomposition respectivement de phosphine ($PH_3$), de triméthylphosphine (TMT) ou de triéthylphosphine (TEP) ; d'arsine ($AsH_3$) ou de triméthylarsine (TMAs) et d'hydrure d'antimoine ($SbH_3$) ou de triméthylantimoine (TMS).

Le dépôt de couches contenant du zinc, du cadmium ou du mercure se fait par décomposition respectivement de diéthylzinc (DEZ), de triméthylzinc (TMZ) ou de diméthylzinc (DMZ) ; de diméthylcadmium (DMC) et de diméthylmercure (DMHg). Pour le dépôt de couches contenant du soufre, du sélénium ou du tellure, on utilise respectivement des vapeurs d'hydrogène sulfuré ($H_2S$) ; d'hydrogène sélénié ($H_2Se$) ou de diméthylsélénium (DMSe) et de triméthyltellure (DMTe) ou de diéthyltellure (DETe).

L'épitaxie d'une couche semi-conductrice III-V dopée p est obtenue en soumettant en outre le matériau sur lequel doit être réalisée l'épitaxie sélective à un organométallique d'un élément II de la classification périodique des éléments. Cet organométallique est en général l'un des polyalkyles métalliques cités précédemment.

Pour obtenir une couche épitaxiée III-V dopée n, on soumet par ailleurs le matériau à un organométallique ou à un composé hydrogéné d'un élément de la colonne VI du tableau périodique des éléments, tel que ceux cités précédemment. Il est aussi possible d'utiliser un organométallique ou un composé hydrogéné de la colonne IV du tableau périodique des éléments. A cet effet, on peut utiliser le silane ($SiH_4$) ou le triméthylétain (DMS).

Pour obtenir une couche épitaxiée II-VI dopée n, on soumet le matériau à des vapeurs d'un organométallique d'un élément de la colonne III tel que le TMG.

Tous ces polyalkyles et composés hydrogénés sont ceux ordinairement utilisés pour la croissance en OMCVD de couches III-V ou II-VI, dopées ou non, et sont disponibles dans le commerce.

En général, les épitaxies de couches III-V et II-VI sont réalisées sur un substrat de même nature que les couches, c'est-à-dire respectivement en matériau III-V ou II-VI. Il est toutefois possible d'utiliser un substrat de nature différente : cas d'épitaxie sélective de ZnSe sur un substrat en GaAs.

L'halogènure de L'élément V ou VI utilisé pour l'épitaxie sélective peut être un chlorure, un bromure ou un fluorure. De préférence, on utilise un chlorure.

Dans le cas particulier d'une épitaxie sélective de GaAs ou de $Ga_{1-x}Al_x$ As avec $0<x\leq1$, on utilise comme halogénure de sélectivité du chlorure d'arséniure ($AsCl_3$). Ce produit a l'avantage d'être disponible dans le commerce sous forme pure.

Pour une épitaxie de GaInAsP, on peut utiliser du $AsCl_3$ ou du $PCl_3$ comme halogénure de sélectivité ; pour une épitaxie de HgCdTe, on utilise HCl ; pour une épitaxie de ZnSe, on utilise $SeCl_4$ comme halogénure de sélectivité et pour l'épitaxie de $ZnS_{1-y}$-$Se_y$ avec $0<y<1$, on utilise soit $SeCl_4$, soit $SCl_4$ comme halogénure de sélectivité.

Les procédés de l'invention permettent en outre, lors de l'étape c) une gravure des zones non masquées du matériau III-V ou II-VI sur lesquelles doit être réalisée l'épitaxie sélective, dans le même bâti de croissance OMCVD que l'épitaxie. Ainsi, en éliminant le transfert du matériau III-V ou II-VI du bâti de gravure vers le bâti d'épitaxie sélective, on diminue les risques de pollution de la surface du matériau sur lequel doit être effectuée l'épitaxie. De plus, cette gravure est anisotrope.

Comme l'épitaxie sélective, la gravure des zones non masquées du matériau III-V ou II-VI sur lesquelles doit être réalisée l'épitaxie est réalisée à pression atmosphérique à l'aide de vapeur d'au moins un halogénure de l'élément III, V, II ou VI constituant le matériau à graver.

Pour la gravure de GaAs, on utilise avantageusement un halogénure de l'élément V et en particulier du chlorure d'arsénic. Pour une gravure de GaInAsP, on peut utiliser $PCl_3$ ou $AsCl_3$ ; pour une gravure de HgCdTe, on peut utiliser du HCl, et pour une gravure de ZnSe, on utilise, soit du $SeCl_4$, soit du $SeCl_4$ selon la composition du matériau à graver.

Le procédé de l'invention peut être mis en oeuvre avec tout bâti de croissance OMCVD existant à condition de lui adjoindre une ligne d'introduction de l'halogénure de l'élément III, V, II ou VI pour l'épitaxie et/ou la gravure du matériau III-V ou II-VI.

Les températures de croissance utilisées sont celles couramment utilisées. Pour l'épitaxie de GaAs, les températures de croissance généralement utilisées sont comprises dans la gamme allant de 650°C-750°C. Aussi, de préférence, on utilise cet intervalle de température pour la croissance. Toutefois, il est possible de travailler en dehors de cette gamme de température sans nuire à la sélectivité du dépôt.

L'épitaxie sélective et la gravure de matériau III-V se faisant à haute température, c'est-à-dire supérieure à 600°C, le matériau utilisé pour constituer le masque d'épitaxie et/ou de gravure doit être stable à cette température, ce qui exclut notamment les résines photosensibles généralement utilisées en microélectronique.

Le masque de gravure est en particulier un diélectrique ou un métal et par exemple du nitrure de silicium, du dioxyde de silicium ou encore du tungstène déposé sous forme polycristalline.

Selon l'invention, il est possible d'obtenir une épitaxie sélective pour toutes les valeurs du rapport R polyalkyle de l'élément III (ou II)/halogénure de l'élément V (ou VI) tel que 0<R≤6 et de préférence 1,5≤R≤6. Toutefois, la valeur optimum de ce rapport correspond à la plus forte valeur de ce rapport, c'est-à-dire à celle donnant la plus faible valeur de l'halogénure de l'élément III (ou II) dans le bâti de croissance. En effet, c'est sous ces conditions que l'on obtient le plus bel état de surface de la couche épitaxiée.

Dans le cas particulier d'épitaxie le GaAs et de $Ga_{1-x}Al_x$ As le rapport de $AsH_3$/TMG optimum est de 20.

Le procédé de l'invention peut s'appliquer à un matériau comportant n'importe quelle orientation cristallographique. Toutefois, on utilise généralement la face <001> car ce plan comporte deux plans de clivage <110> et <1$\bar{1}$0> généralement utilisé en optoélectronique. Il est à noter que cette orientation du matériau n'influe pas sur la sélectivité de la croissance.

D'autres caractéritiques et avantages de l'invention ressortiront mieux de la description qui va suivre, donnée à titre illustratif et non limitatif en référence aux dessins annexés dans lesquels :

- la figure 1 illustre schématiquement les différentes étapes du procédé conforme à l'invention,
- la figure 2 représente schématiquement un bâti d'épitaxie pour la mise en oeuvre du procédé conforme à l'invention, et
- la figure 3 représente schématiquement la fabrication selon l'invention d'une structure laser-guide d'onde, intégrée.

La description ci-après se rapporte à l'épitaxie sélective de GaAs ou de GaAlAs sur un substrat en GaAs. Toutefois, comme on l'a vu précédemment, l'invention est d'application beaucoup plus générale.

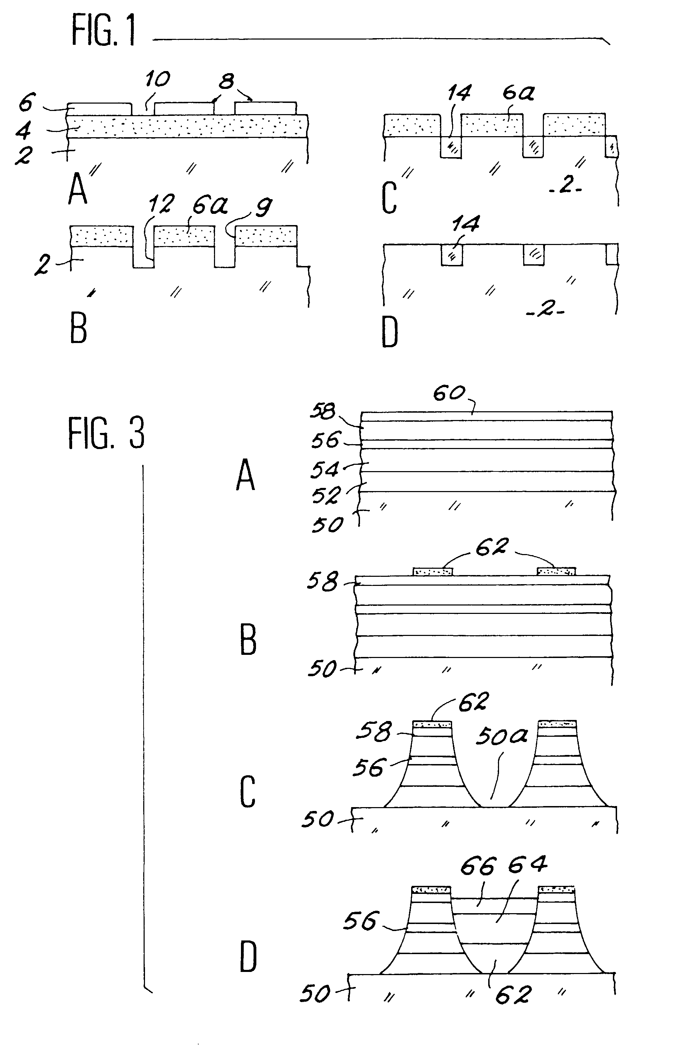

La figure 1 illustre schématiquement, en coupe transversale, les différentes étapes du procédé conforme à l'invention.

Comme représenté sur la partie A, on part d'un substrat monocristallin 2 de GaAs dont la surface 4 sur laquelle doit se faire l'épitaxie sélective est parallèle au plan <001>. Sur ce substrat 2 on dépose une couche 6 de nitrure de silicium ($Si_3N_4$) dans laquelle on va réaliser le masque de gravure et d'épitaxie sélective.

On forme alors à la surface de la couche 6 un masque de photolithographie 8 en résine photosensible par les procédés connus. Ce masque 8 comporte des ouvertures 10 en regard des zones du substrat 2 sur lesquelles doit être réalisée l'épitaxie sélective.

On effectue alors une gravure de la couche de masque 6 pour en éliminer les zones non masquées par la résine 8. Cette gravure est une gravure chimique utilisant une solution d'acide fluorhydrique. Après élimination du masque de résine 8 de façon connue par voie chimique, on obtient la structure représentée sur la partie B de la figure 1.

Les motifs 6a de la couche de masque obtenus ainsi que les ouvertures 9 sont constitués de bandes parallèles à la direction <110> et <1$\bar{1}$0> du substrat 2.

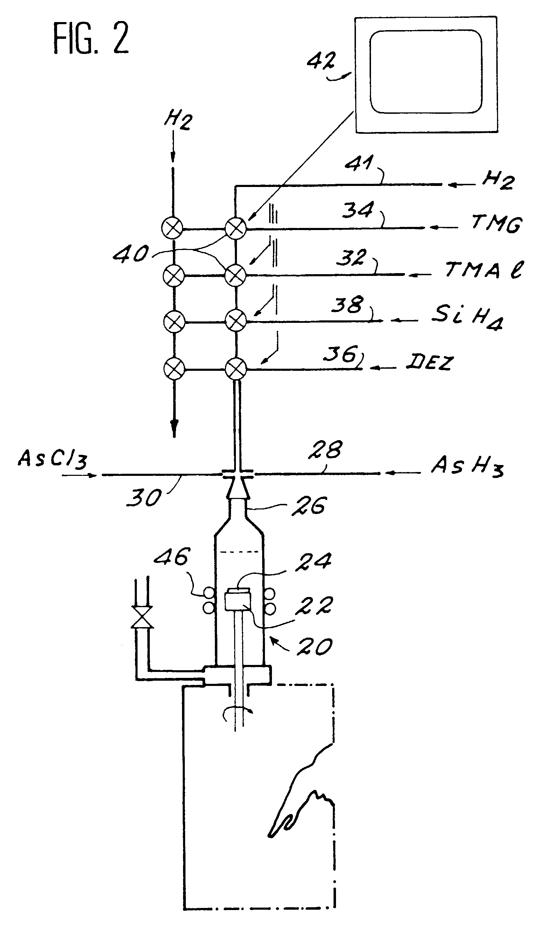

On effectue alors une gravure des régions du substrat 2 non recouvertes de nitrure de silicium. Cette gravure est réalisée avec du $AsCl_3$ dans un bâti OMCVD de type connu auquel on a rajouté une alimentation en $AsCl_3$, comme représenté sur la figure 2. Cette gravure est réalisée à pression atmosphérique. Les trous formés dans le substrat portent la référence 12 sur la figure 1 (A).

On effectue alors, dans le même bâti OMCVD, une épitaxie sélective de GaAs. La structure obtenue est celle de la partie C de la figure 1. Le GaAs épitaxié dans les trous 12 du substrat 2 porte la référence 14.

Cette épitaxie sélective est réalisée en chauffant le substrat 2 de 650°C à 750°C et en utilisant un mélange de TMG, $AsH_3$ et $AsCl_3$ dilué dans le gaz vecteur constitué en général d'hydrogène. L'épitaxie est réalisée à pression atmosphérique.

Dans ces conditions, on obtient une épitaxie totalement sélective, aucune cristallite n'apparaissant sur les motifs 6a de nitrure de silicium, bien que la surface de diélectrique soit plus importante que la surface de GaAs exposée aux gaz de croissance. De plus, les plans crystallographiques qui se développent pendant la croissance épitaxiale suivent la direction des motifs 6a, c'est-à-dire la direction <110> ou <1$\bar{1}$0>.

Les inventeurs ont étudié l'influence du rapport TMG/$AsCl_3$ sur la vitesse de croissance ; ils ont constaté qu'elle augmentait avec ce rapport.

Pour expliquer ces résultats, ils proposent le mécanisme réactionnel suivant :

$AsCl_3$ se décompose selon la réaction (1) suivante :

$$AsCl_3 + 3/2H_2 = 1/4As_4 + 3HCl \qquad (1)$$

Le gaz chlorhydrique (HCl) formé s'adsorbe alors sur le diélectrique, bloquant la croissance. Dans les ouvertures 12, deux réactions sont en compétition, la gravure régie par l'équation (2) suivante :

$$GaAs + HCl = GaCl + 1/4As + 1/2H_2 \qquad (2)$$

et la croissance régie par l'équation (3) qui suit :

$$Ga(CH_3) + AsH_3 = GaAs + 3CH_4 \qquad (3)$$

En faisant varier le rapport TMG/$AsCl_3$, on peut favoriser l'une ou l'autre des réactions et on peut donc faire varier la vitesse de dépôt.

La valeur optimum du rapport TMG/$AsCl_3$ est celle correspondant à la plus faible valeur de $AsCl_3$ car dans ces conditions, on obtient le plus bel état de surface des rubans épitaxiés 14 et des motifs 6a du masque. Cette valeur optimum est 20.

Après élimination des motifs 6a du masque par gravure chimique, on obtient la structure représentée sur la partie D de la figure 1.

En jouant sur la durée de l'épitaxie et sur le débit des gaz, on peut former des zones épitaxiées 14 dont la surface affleure celle du substrat 2. On obtient ainsi une structure parfaitement plane telle que représentée.

De la même façon les inventeurs ont réalisé une épitaxie sélective de $Ga_{1-x}Al_xAs$ avec x=0,2 en utilisant du TMAL comme gaz supplémentaire d'épitaxie. Les conditions opératoires étaient identiques de même que les résultats obtenus.

Sur la figure 2, on a représenté schématiquement un bâti OMCVD destiné à la gravure d'un substrat III-V et à l'épitaxie sélective d'une couche semi-conductrice III-V sur ce dernier.

Ce dispositif à configuration verticale comporte un réacteur en verre de silice 20, dans lequel est placé un suscepteur 22 supportant le substrat 24 monocristallin en matériau III-V masqué, à traiter.

Les gaz nécessaires à la gravure du substrat et à la croissance épitaxiale sélective sont introduits à l'une des extrémités 26 du réacteur 20, l'autre extrémité étant utilisée pour l'évacuation des gaz de réaction ($CH_4$, GaCl, etc.) et des gaz n'ayant pas réagi.

Sur cette figure 2, on a représenté une conduite 28 destinée à l'introduction d'arsine dans le réacteur 20 ; une conduite 30 destinée à l'introduction d'$AsCl_3$ ; une conduite 32 d'introduction de TMAl et une conduite 34 d'introduction de TMG.

Afin de réaliser un dopage de type n ou p des zones épitaxiées, ce dispositif comprend en outre une conduite 36 d'introduction de DEZ et une conduite 38 d'alimentation en $SiH_4$.

Ces différentes conduites sont équipées d'électrovannes 40 commandées de façon connue par un circuit électronique de commande 42 (du type microordinateur). On trouve en outre une conduite 41 d'introduction en gaz vecteur consistant en de l'hydrogène.

Le pilotage de ce bâti OMCVD se fait de façon connue.

Le réacteur en verre en silice 20 est placé dans un four à lampes à halogène, destiné au chauffage du substrat lors de la gravure et de l'épitaxie ; ces lampes portent la référence 46.

Avec le procédé de l'invention, on peut réaliser l'intégration d'un laser et d'un guide d'onde sur un même substrat, comme représenté schématiquement sur la figure 3.

Sur un substrat 50 monocristallin de GaAs d'orientation <100> on effectue successivement dans un bâti OMCVD l'épitaxie des différentes couches du laser en utilisant les composés organométalliques et/ou hydrogénés décrits précédemment : par exemple l'épitaxie d'une couche tampon 52 de GaAs dopée n, l'épitaxie de la couche inférieure de confinement en $Ga_{1-x}Al_xAs$ dopée n avec x=0,30, puis l'épitaxie de la couche active 56 en GaAs non intentionnellement dopée, l'épitaxie de la couche supérieure de confinement 58 en $Ga_{1-x}Al_xAs$ dopée p avec x=0,30 et enfin la couche de contact 60 en GaAs dopée p+.

On réalise alors un masque 62 en nitrure de silicium comme décrit à la figure 1, fixant les dimensions latérales du laser ainsi que celles du guide d'onde à réaliser.

On effectue alors avec le dispositif représenté sur la figure 2, une gravure des couches épitaxiées 60-52 jusqu'à mise à nu des régions du substrat 50a sur lesquelles doit être réalisée l'épitaxie sélective des différentes couches du guide d'onde. Cette gravure est réalisée avec du $AsCl_3$ à pression atmosphérique. Le laser est ainsi réalisé.

On effectue alors, dans le même bâti, une épitaxie sélective d'une couche 62 de $Ga_{1-x}Al_xAs$ avec x=0,30 constituant la couche inférieure de confinement du guide d'onde, puis l'épitaxie d'une couche 64 de GaAs constituant la couche guide puis l'épitaxie d'une couche 66 de $Ga_{1-x}Al_xAs$ avec x=0,30 constituant la couche supérieure de confinement du guide. Les épaisseurs des couches 62, 64 et 66 sont telles que la couche guide 64 est située dans le prolongement de la couche active 56 du laser.

Après élimination du masque de nitrure 62, on obtient une structure plane.

Les conditions de dépôt et de gravure sont les mêmes que celles décrites en référence à la figure 1.

Au lieu de faire croître les couches 62 à 66, on peut faire croître une couche épaisse de $Ga_{1-x}Al_xAs$ dopée p- avec x=0,35 à 0,40. On obtient alors une structure laser seule enterrée à confinement latéral.

Le procédé de l'invention permet l'obtention de structures laser-guide d'onde ou structures lasers seules à surface plane contrairement aux procédés classiques de réalisation de ces structures.

Au lieu de réaliser ces structures intégrées sur un substrat en GaAs, il est possible de les réaliser sur un substrat en InP. Il suffit pour cela de remplacer les couches de GaAs par de l'InP et les couches de GaAlAs par des couches de GaAsInP.

## Revendications

1. Procédé d'épitaxie sélective d'une couche semi-conductrice constituée d'au moins un élément III et d'au moins un élément V, comportant les étapes suivantes :

   a) - déposer sur un matériau monocristallin (2) III-V une couche de masque (6), en matériau diélectrique ou en métal, résistant à l'épitaxie,

   b) - graver la couche de masque pour y former des ouvertures (9) correspondant aux zones du matériau monocristallin sur lesquelles doit être réalisée l'épitaxie sélective,

c) - graver (12) dans un bâti OMCVD à pression atmosphérique des zones non masquées du matériau monocristallin à l'aide d'un ou plusieurs halogénures d'un de ces éléments III ou V constituant le matériau monocristallin,

d) - épitaxier dans le même bâti OMCVD la couche semiconductrice (14) sur les zones du matériau monocristallin sur lesquelles doit être réalisée l'épitaxie sélective, l'étape d) consistant à soumettre, sous pression atmosphérique, ledit matériau monocristallin masqué et gravé, simultanément à des vapeurs d'espèces chimiques d'au moins un élément III et d'au moins un élément V, ainsi qu'à des vapeurs d'acide chlorhydrique ou d'au moins un halogénure d'un élément V, les éléments III et V des espèces chimiques et de l'halogénure étant ceux destinés à constituer la couche semi-conductrice, lesdites espèces chimiques étant des organo-métalliques et/ou des composés hydrogénés.

2. Procédé selon la revendication 1, caractérisé en ce que l'élément III est choisi parmi le gallium, l'indium, l'aluminium et leurs mélanges et en ce que l'élément V est choisi parmi le phosphore, l'arsenic, l'antimoine et leurs mélanges.

3. Procédé selon l'une quelconque des revendications 1 ou 2, caractérisé en ce que l'halogénure de l'élément V est un chlorure.

4. Procédé selon l'une des revendications 1 à 3, appliqué à l'épitaxie de GaAs ou de $Ga_{1-x}Al_xAs$, avec $0<x\leq1$, caractérisé en ce qu'on utilise du chlorure d'arséniure comme halogénure.

5. Procédé selon l'une des revendications 1 à 4, appliqué à l'épitaxie d'une couche III-V dopée n ou p, caractérisé en ce qu'on soumet en outre le matériau monocristallin à des vapeurs d'organométallique et/ou de composé hydrogéné d'un élément respectivement dopant n ou p.

6. Procédé selon la revendication 4, caractérisé en ce que lors de l'étape c) la gravure est réalisée à l'aide de vapeurs d'au moins un halogénure d'arséniure As.

7. Procédé selon la revendication 1, appliqué à la gravure de GaAs, caractérisé en ce que lors de l'étape c) on utilise du chlorure d'arséniure pour ladite gravure.

8. Procédé d'épitaxie sélective d'une couche semi-conductrice constituée d'au moins un élément II et d'au moins un élément VI, comportant les étapes suivantes :

a) - déposer sur un matériau monocristallin (2) II-VI une couche de masque (6), en matériau diélectrique ou en métal, résistant à l'épitaxie,

b) - graver la couche de masque pour y former des ouvertures (9) correspondant aux zones du matériau monocristallin sur lesquelles doit être réalisée l'épitaxie sélective,

c) - graver (12) dans un bâti OMCVD à pression atmosphérique des zones non masquées du matériau monocristallin à l'aide d'un ou plusieurs halogénures d'un de ces éléments II ou VI constituant le matériau monocristallin,

d) - épitaxier dans le même bâti OMCVD la couche semiconductrice (14) sur les zones du matériau monocristallin sur lesquelles doit être réalisée l'épitaxie sélective, l'étape d) consistant à soumettre, sous pression atmosphérique, ledit matériau monocristallin masqué et gravé simultanément à des vapeurs d'espèces chimiques d'au moins un élément II et d'au moins un élément VI, ainsi qu'à des vapeurs d'acide chlorhydrique ou d'au moins un halogénure d'un élément VI, les éléments II et VI des espèces chimiques et de l'halogénure étant ceux destinés à constituer la couche semi-conductrice, lesdites espèces chimiques étant des organo-métalliques et/ou des composés hydrogénés.

9. Procédé selon la revendication 8, caractérisé en ce que l'élément II est choisi parmi le zinc, le cadmium, le mercure et leurs mélanges et en ce que l'élément VI est choisi parmi le soufre, le sélénium, le tellure et leurs mélanges.

10. Procédé selon l'une quelconque des revendications 8 ou 9, caractérisé en ce que l'halogénure de l'élément VI est un chlorure.

11. Procédé selon l'une des revendications 8 à 10, appliqué à l'épitaxie d'une couche II-VI dopée n ou p, caractérisé en ce qu'on soumet en outre le matériau monocristallin à des vapeurs d'organométallique et/ou de composé hydrogéné d'un élément respectivement dopant n ou p.

**Patentansprüche**

1. Verfahren zur selektiven Epitaxie einer halbleitenden Schicht, bestehend aus mindestens einem III-Element und mindestens einem V-Element, die folgenden Schritte umfassend:

a) - Abscheiden einer Maskenschicht (6) aus dielektrischem Material oder aus Metall, beständig bei der Epitaxie, auf einem einkristallinen III-V-Material (2),

b) - Ätzen der Maskenschicht, um darauf Öffnungen (9) zu bilden, die den Zonen des einkristallinen Materials entsprechen, auf welchen die selektive Epitaxie ausgeführt werden soll,

c) - Ätzen (12) der nicht maskierten Zonen des einkristallinen Materials mit Hilfe von einem oder mehreren Halogeniden eines der III- oder V-Elemente, die das einkristalline Material bilden, in einem MOCVD-Wachstumsapparat bei Atmosphärendruck,

d) - Epitaxie der halbleitenden Schicht (14) auf den Zonen des einkristallinen Materials, auf welchen die selektive Epitaxie erfolgen soll, in demselben MOCVD-Wachstumsapparat, wobei Schritt d) darin besteht, das genannte maskierte und geätzte einkristalline Material unter Atmosphärendruck gleichzeitig Dämpfen chemischer Spezies mindestens eines 111-Elements und mindestens eines V-Elements sowie Dämpfen von Salzsäure oder mindestens eines Halogenids eines V-Elements auszusetzen, wobei die III- und V-Elemente der chemischen Spezies und des Halogenids diejenigen sind, die dazu bestimmt sind, die halbleitende Schicht zu bilden, während die genannten chemischen Spezies metallorganische und/oder wasserstoffhaltige Verbindungen sind.

2. Verfahren nach Anspruch 1, dadurch gekennzeichnet, daß das III-Element unter Gallium, Indium, Aluminium und ihren Mischungen gewählt ist und daß das V-Element unter Phosphor, Arsen, Antimon und ihren Mischungen gewählt ist.

3. Verfahren nach einem der Ansprüche 1 oder 2, dadurch gekennzeichnet, daß das Halogenid des V-Elements ein Chlorid ist.

4. Verfahren nach einem der Ansprüche 1 bis 3, angewandt auf die Epitaxie von GaAs oder von $Ga_{1-x}Al_xAs$ mit $0<x\leq1$, dadurch gekennzeichnet, daß man als Halogenid Arsentrichlorid verwendet.

5. Verfahren nach einem der Ansprüche 1 bis 4, angewandt auf die Epitaxie einer n- oder p-dotierten III-V-Schicht, dadurch gekennzeichnet, daß man darüber hinaus das einkristalline Material Dämpfen einer metallorganischen und/oder einer wasserstoffhaltigen Verbindung eines n- bzw. p-dotierenden Elements aussetzt.

6. Verfahren nach Anspruch 4, dadurch gekennzeichnet, daß in Schritt c) das Ätzen mit Hilfe von Dämpfen mindestens eines Arsen(III)-halogenids ausgeführt wird.

7. Verfahren nach Anspruch 1, angewandt auf das Ätzen von GaAs, dadurch gekennzeichnet, daß man in Schritt c) Arsentrichlorid für das genannte Ätzen verwendet.

8. Verfahren zur selektiven Epitaxie einer halbleitenden Schicht, bestehend aus mindestens einem II-Element und mindestens einem VI-Element, die folgenden Schritte umfassend:

a) - Abscheiden einer Maskenschicht (6) aus dielektrischem Material oder aus Metall, beständig bei der Epitaxie, auf einem einkristallinen II-VI-Material (2),

b) - Ätzen der Maskenschicht, um darauf Öffnungen (9) zu bilden, die den Zonen des einkristallinen Materials entsprechen, auf welchen die selektive Epitaxie ausgeführt werden soll,

c) - Ätzen (12) der nicht maskierten Zonen des einkristallinen Materials mit Hilfe von einem oder mehreren Halogeniden eines der II- oder VI-Elemente, die das einkristalline Material bilden, in einem MOCVD-Wachstumsapparat bei Atmosphärendruck,

d) - Epitaxie der halbleitenden Schicht (14) auf den Zonen des einkristallinen Materials, auf welchen die selektive Epitaxie erfolgen soll, in demselben MOCVD-Wachstumsapparat, wobei Schritt d) darin besteht, das genannte maskierte und geätzte einkristalline Material unter Atmosphärendruck gleichzeitig Dämpfen chemischer Spezies mindestens eines II-Elements und mindestens eines VI-Elements sowie Dämpfen von Salzsäure oder mindestens eines Halogenids eines VI-Elements auszusetzen, wobei die II- oder VI-Elemente der chemischen Spezies und des Halogenids diejenigen sind, die dazu bestimmt sind, die halbleitende Schicht zu bilden, während die genannten chemischen Spezies metallorganische und/oder wasserstoffhaltige Verbindungen sind.

9. Verfahren nach Anspruch 8, dadurch gekennzeichnet, daß das II-Element unter Zink, Cadmium, Quecksilber und ihren Mischungen gewählt ist und daß das VI-Element unter Schwefel, Selen, Tellur und ihren Mischungen gewählt ist.

10. Verfahren nach einem der Ansprüche 8 oder 9, dadurch gekennzeichnet, daß das Halogenid des VI-Elements ein Chlorid ist.

11. Verfahren nach einem der Ansprüche 8 bis 10, angewandt auf die Epitaxie einer n- oder p-dotierten II-VI-Schicht, dadurch gekennzeichnet, daß man darüber hinaus das einkristalline Material Dämpfen einer metallorganischen und/oder einer wasserstoffhaltigen Verbindung eines n- bzw. p-dotierenden Elements aussetzt.

## Claims

1. Process for the selective epitaxy of a semiconductor layer constituted by at least one III element and at least one V element, incorporating the following stages:

   a) depositing on a respectively III-V or II-VI monocrystalline material (2) an epitaxy-resistant masking layer (6) of dielectric material or metal,

   b) etching the masking layer in order to form therein openings (9) facing the areas of the monocrystalline material on which selective epitaxy is to be carried out,

   c) etching (12) in an OMCVD frame at atmospheric pressure unmasked areas of the monocrystalline material with the aid of one or more halides of one of these III or V elements constituting the monocrystalline material,

   d) epitaxying in the same OMCVD frame the semiconductor layer (14) on areas of the material on which selective epitaxy is to take place, stage d) consisting of subjecting, under atmospheric pressure, said monocrystalline, etched masking material simultaneously to vapours of chemical species of at least one III element and at least one V element, as well as to hydrochloric acid vapours or vapours of at least one halide of a V element, the III and V elements of the chemical species and the halide being those intended to constitute the semiconductor layer, said chemical species being organometallic and/or hydrogen compounds.

2. Process according to claim 1, characterized in that the III element is chosen from among gallium, indium, aluminium and mixtures thereof and in that the V element is chosen from among phosphorus, arsenic, antimony and mixtures thereof.

3. Process according to either of the claims 1 and 2, characterized in that the halide of the V element is a chloride.

4. Process according to any one of the claims 1 to 3 applied to the epitaxy of GaAs or $Ga_{1-x}Al_xAs$ with $0 < x < 1$, characterized in that arsenic trichloride is used as the halide.

5. Process according to any one of the claims 1 to 4 applied to the epitaxy of a n or p-doped III-V or II-VI layer, characterized in that the monocrystalline material is also exposed to the vapours of an organometallic compound and/or a hydrogen compound of a respectively n or p-doped element.

6. Process according to claim 4, characterized in that during stage c), etching takes place with the aid of vapours of at least one arsenide halide.

7. Process according to claim 1 applied to the etching of GaAs, characterized in that during stage c) use is made of an arsenide chloride for said etching.

8. Process for the selective epitaxy of a semiconductor layer constituted by at least one II element and at least one VI element involving the following stages:

   a) depositing on a II-VI monocrystalline material (2) a masking layer (6) of a dielectric material or a metal, which is resistant to epitaxy,

   b) etching the masking layer in order to form therein the openings (9) corresponding to the areas of the monocrystalline material on which the selective epitaxy is to take place,

   c) etching (12) in an OMCVD frame at atmospheric pressure unmasked areas of the monocrystalline material with the aid of one or more halides of one of said II or VI elements constituting the monocrystalline material,

   d) epitaxying in the same OMCVD frame the semiconductor layer (14) on areas of the monocrystalline material on which selective epitaxy is to take place, stage d) consisting of subjecting, under atmospheric pressure, said mask, etched, monocrystalline material simultaneously to the action of vapours of chemical species of at least one II element and at least one VI element, as well as to vapours of hydrochloric acid or at least one halide of a VI element, the II and VI elements of the chemical species and the halide being those intended to constitute the semiconductor layer, said chemical species being organometallic and/or hydrogen compounds.

9. Process according to claim 8, characterized in that element II is chosen from among zinc, cadmium, mercury and mixtures thereof and in that element VI is chosen from among sulphur, selenium, tellurium and mixtures thereof.

10. Process according to either of the claims 8 and 9, characterized in that the halide of the VI element is a chloride.

11. Process according to any one of the claims 8 to 10 applied to the epitaxy of a n or p-doped II-VI layer, characterized in that the monocrystalline material is also exposed to organometallic and/or hydrogen compound vapours of a respectively n or p-doping element.

FIG. 1

A

B

C

D

FIG. 3

A

B

C

D

# FIG. 2